# EUROPÄISCHE PATENTSCHRIFT

(11) **EP 0 914 029 B1**
(45) Veröffentlichungstag und Bekanntmachung des Hinweises auf die Patenterteilung: **25.08.2004**
(21) Anmeldenummer: 98119934.2
(22) Anmeldetag: 21.10.1998
(51) Int. Cl.: H05K 7/14

(54) **Modulares Automatisierungsgerät und Baugruppe eines modularen Automatisierungsgerätes**
Modular automation apparatus and unit for a modular automation apparatus
Automate modulaire et unité d'un automate modulaire

(30) Priorität: 03.11.1997 DE 19748530
(43) Veröffentlichungstag der Anmeldung: 06.05.1999
(73) Patentinhaber: SIEMENS AKTIENGESELLSCHAFT, 80333 München (DE)
(72) Erfinder: Deinhardt, Günther, Dipl.-Ing., 92224 Amberg (DE); Meiler, Werner, 92286 Rieden (DE)

(56) Entgegenhaltungen:
- EP-A- 0 236 711
- EP-A- 0 661 915
- EP-A- 0 768 728
- DE-A- 4 402 002

## Beschreibung

Die Erfindung bezieht sich auf ein modulares Automatisierungsgerät mit anreihbaren, auf einer Tragschiene gehaltenen Basismodulen mit Außenkontakten, wobei das Basismodul mit einem Elektronikmodul kontaktierbar ist, das selbst keine Außenkontakte aufweist, und wobei das Basismodul mit einem benachbarten Basismodul kontaktierbar ist.

Ein gattungsgemässes Automatisierungsgerät ist aus der DE 36 03 750 C2 bekannt.

Aus der DE-OS 44 02 001 A1 ist ebenfalls ein modulares Automatisierungsgerät mit anreihbaren, auf einer Tragschiene gehaltenen Basismodulen mit Außenkontakten, wobei das Basismodul mit einem Elektronikmodul kontaktierbar ist, das selbst keine Außenkontakte aufweist, bekannt. Das Basismodul der DE-OS 44 02 001 A1 ist mit einem gegebenenfalls benachbarten Basismodul kontaktierbar. Dazu besitzt das Basismodul einen flachen Bodenkanal, in dem eine Datenbusleitung und eine Stromversorgung geführt sind.

Mit einem Basismodul sind mehrere Elektronikmodule kontaktierbar.

Aus der DE-OS 44 02 002 A1 sind auf einer Tragschiene gehaltene benachbart plazierbare E/A-Module bekannt, wobei die einzelnen Module jeweils auf ihrer einen Außenseite Federkontakte und auf der anderen Außenseite durch die Federkontakte kontaktierbare Kontaktstellen aufweisen, so daß die in die E/A-Module integrierten Datenbusleitungen, Stromversorgungsleitungen und auch die Leistungsstromversorgung automatisch beim Aneinanderreihen der einzelnen Module durchkontaktiert bzw. durchgeschleift werden.

Die Aufgabe der vorliegenden Erfindung besteht darin, anreihfähige Module für ein Automatisierungsgerät anzugeben, die einerseits sowohl die Weiterleitung von Steuersignalen als auch die Weiterleitung von im Vergleich zu den Steuersignalen vergleichsweise hohen Strömen gestatten und andererseits auch die Nachbarmodule bei hohen Schock- und Rüttelbeanspruchungen sicher kontaktieren müssen.

Diese Aufgabe wird mit einem modularen Automatisierungsgerät mit anreihbaren, auf einer Tragschiene gehaltenen Basismodulen mit Außenkontakten, wobei das Basismodul mit einem Elektronikmodul kontaktierbar ist, das selbst keine Außenkontakte aufweist, und wobei das Basismodul mit einem benachbarten Basismodul kontaktierbar ist,
- wobei das Basismodul neben Steuerleitungen auch stromtragfähige Verbindungsleitungen aufweist, die zur Kontaktierung auf der einen Außenseite des Basismoduls in ersten Kontaktmitteln und auf der gegenüberliegenden Außenseite des Basismoduls in zweiten, zu den ersten Kontaktmitteln korrespondierend ausgebildeten Gegenkontaktmitteln münden, dadurch gelöst,
- daß in räumlichem Zusammenhang mit den ersten Kontaktmitteln ein Schutzkragen vorgesehen ist und in räumlichem Zusammenhang mit den Gegenkontaktmitteln eine formschlüssige, korrespondierende Ausdehnung vorgesehen ist.

Die Erfindung bezieht sich dabei sowohl auf das Automatisierungsgerät mit den einzelnen erfindungsgemäß ausgestalteten Modulen/Baugruppen als auch auf die Module/Baugruppen selbst.

Aus der DE 36 03 750 C2 ist bekannt, die Basismodule auf ein Tragprofil aufzuschwenken und unten an dem Profil zu verrasten. Die Baugruppen verhaken sich dabei mit einem seitlich vorstehenden einschwenkbaren Haken, wobei dies nicht spielfrei zu erreichen ist. Die elektrische Verbindung wird über ein separat zu steckendes Flachbandkabel hergestellt. Diese bekannte Lösung ist zum einen hinsichtlich des relativ hohen Handlingsaufwands und zum anderen hinsichtlich des hohen materiellen Aufwands für Flachbandkabel und zugehörigen Steckverbindern verbesserungswürdig. Weiterhin ist eine Eliminierung des mit der Flachbandkabellösung verbunden relativ hohen Durchgangswiderstands wünschenswert. Ferner sind in der bekannten Lösung stromtragfähige Verbindungen nicht angesprochen.

Der neue Aufbau unterscheidet sich von dem aus der DE 36 03 750 C2 bekannten Aufbau in folgenden Punkten: Es handelt sich um einen feinmodularen Aufbau (erweiterbar in 1er Schritten), wobei der Aufbau außer den Steuerleitungen auch noch stromtragfähige Verbindungsleitungen (ca. 10...15A) umfaßt, wobei die Steuer- und Verbindungsleitungen mit geringem Durchgangswiderstand weitergegeben werden.

Aus der DE 44 02 002 A1 ist ein Aufbau bekannt, bei dem die Baugruppen an ihren Seitenflächen Schiebeführungen aufweisen und so die Baugruppen aneinandergefügt werden können und über einen zusätzlichen Mechanismus auf der Tragschiene verrasten. Die Baugruppen weisen zu ihren Nachbarbaugruppen für die Steuerleitung Druckkontakte mit entsprechenden Kontaktflächen auf und für die Stromleitungen Gabelkontakte, die beim Aneinanderschieben in Kontaktmesser eingreifen. Nachteil dieses Aufbaues ist es, daß bei erhöhten Rüttelbelastungen Relativbewegungen zwischen den Kontaktflächen zu einem vorzeitigen Kontakt-Verschleiß führen.

Die Erfindung sowie weitere vorteilhafte Ausgestaltungen der Erfindung gemäß Merkmalen der Unteransprüche werden im folgenden anhand schematisch dargestellter Ausführungsbeispiele in der Zeichnung näher erläutert; darin zeigen:

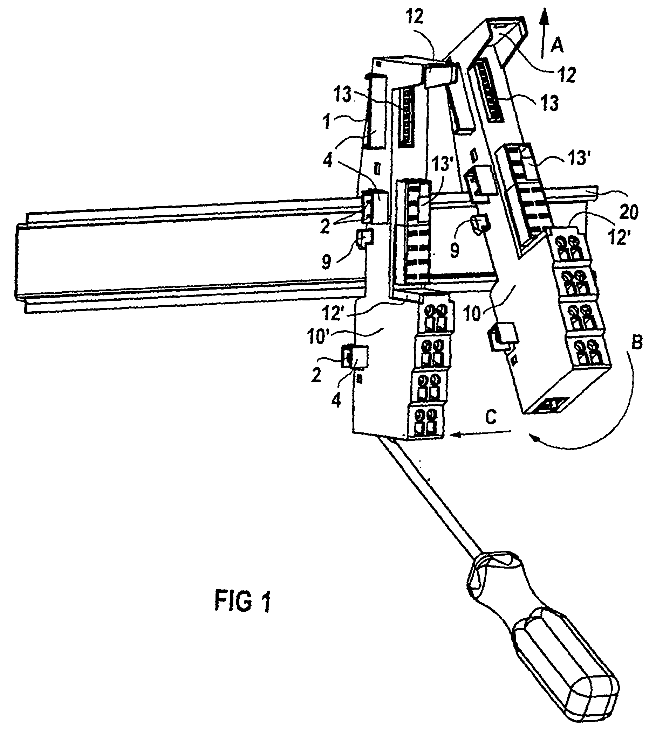

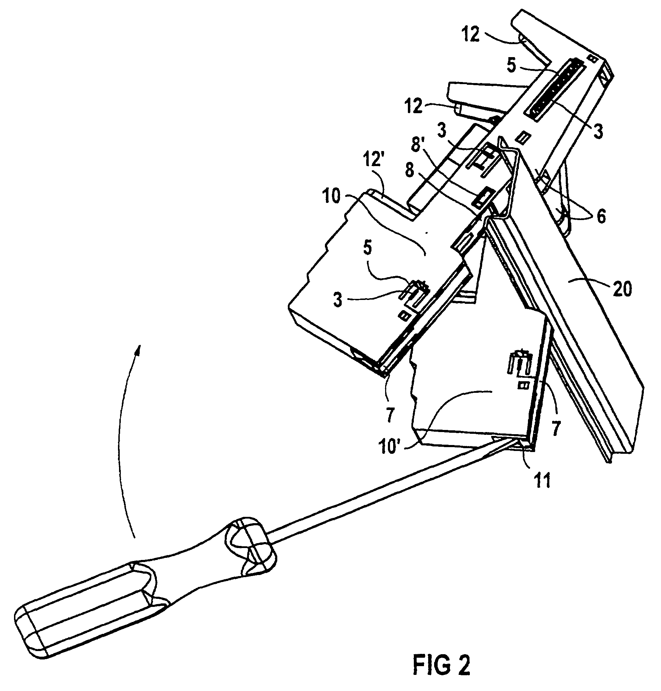

- FIG 1 und FIG 2: die Baugruppen des Automatisierungsgeräts aus verschiedenen Perspektiven.

Gemäß FIG 1 bzw. FIG 2 stehen sowohl bei den Steuerleitungen als auch bei den stromtragfähigen Verbindungsleitungen auf der einen Seite der Baugruppe 10 Kontaktstifte 1 bzw. -messer 2 hervor, wobei die Steuerleitungen in die Kontaktstifte 1 und die stromtragfähigen Verbindungsleitungen in die Kontaktmesser 2 münden. Kontaktstifte 1 und -messer 2 werden beim Aneinanderreihen der Baugruppen 10 in die Kontaktbuchsen 3 der Nachbarbaugruppe 10' gesteckt. Um die Kontaktstifte 1 und -messer 2 sind Schutzkrägen 4 ausgebildet, die mit entsprechenden formschlüssigen Ausnehmungen 5 der Nachbarbaugruppe 10' korrespondieren und durch den formschlüssigen Verbund zur mechanischen Stabilität des Gesamtaufbaues wesentlich beitragen.

In der vorliegenden Beschreibung werden die Bezeichnungen Baugruppe 10 und Basismodul 10 synonym verwendet, da das Basismodul 10 um das in den Zeichnungen nicht dargestellte Elektronikmodul ergänzbar ist, dadurch jedoch das Zusammenwirken eines ersten Basismoduls 10 mit einem benachbarten weiteren Basismodul 10' nicht beeinflußt ist und sich insbesondere die sich damit ergebende Wirkverbindung in gleicher Weise für das Basismodul 10 wie auch für das mit dem Elektronikmodul kontaktierte Basismodul 10 einstellt.

Die Rückseite der Basismodule 10 ist, wie z.B. in FIG 2 ersichtlich, im oberen Bereich zum Einhängen des Basismoduls 10 auf die Tragschiene 20 im wesentlichen hakenförmig ausgestaltet und weist daher eine entsprechende Ausnehmung 6 auf. Des weiteren ist ein beweglich gelagerter, insbesondere gefederter Schieber 7 vorgesehen, der zum einen das Basismodul 10 auf der Tragschiene 20 verrastet und zum anderen durch eine Verlängerung 8, in die ein Haken 9 der Nachbarbaugruppe 10' eingreift, die Nachbarbaugruppe 10' in Steckrichtung sicher verrastet.

Die Verlängerung 8 ist entweder mit dem Schieber 7 direkt oder indirekt verbunden, zumindest aber durch diesen betätigbar, d.h. eine Bewegung des Schiebers 7 führt zu einer entsprechenden Bewegung der Verlängerung 8. Die Verlängerung 8 reicht bis in den Bereich einer Ausnehmung 8', die zur Aufnahme des Hakens 9 bei zusammengeschobenen Baugruppen/Modulen 10 vorgesehen ist. Die Ausnehmung 8' ist dabei so gestaltet, daß der Haken 9 in der Ausnehmung 8' arretiert ist, wenn der Schieber 7 unter Federdruck an der Tragschiene 20 anliegt. Die Arretierung des Hakens 9 ist lösbar, wenn der Schieber 7 gegen den Federdruck bewegt wird. Das Einführen des Hakens 9 in die Ausnehmung 8' ist z.B. beim Zusammenschieben zweier Module/Baugruppen 10 auch ohne separate Betätigung des Schiebers 7 möglich. Die angeschrägte Oberseite des Hakens 9 drückt beim Zusammenschieben die Verlängerung 8 nach unten, so daß die Ausnehmung 8' zum Einführen des Hakens 9 freigegeben wird. Wenn die Nase des Hakens 9 ausreichend weit in die Ausnehmung 8' eingeführt ist, wird die Verlängerung 8 unter der Federkraft des Schiebers 7 nach oben gedrückt, so daß damit der Haken 9 in der Ausnehmung 8' arretiert ist und mithin die beiden benachbarten Baugruppen/Module 10,10' lösbar fest miteinander verbunden sind.

Die Handhabung gestaltet sich dabei besonders einfach und zeichnet sich durch die nachfolgenden Schritte aus: Im ersten Schritt A wird das Basismodul 10 in die Hutschiene 20 eingehängt; im zweiten Schritt B wird das Basismodul 10 auf die Hutschiene 20 aufgeschwenkt und im dritten und letzten Schritt C wird das Basismodul 10 seitlich in Richtung auf ein bereits aufgeschwenktes Nachbarmodul 10' verschoben.

Im Schritt A wird das Basismodul 10 mit der hakenförmigen Ausnehmung 6 zunächst auf der Oberseite der Tragschiene 20 eingehängt, wie dies besonders aus FIG 2 ersichtlich ist. Im Schritt B wird das Basismodul 10 auf die Tragschiene 20 aufgeschwenkt, wobei der beweglich, insbesondere federnd, gelagerte Schieber 7 mit dem Profil der Tragschiene 20 derart zum Eingriff kommt, daß das Basismodul 10 auf der Tragschiene 20 arretiert ist. Auch dieser Aspekt ist anhand der FIG 2 ersichtlich. Im Schritt C wird das Basismodul 10 in Richtung auf ein bereits aufgeschwenktes Nachbarmodul 10' seitlich verschoben, wobei die ersten Kontaktmittel 1,2, die im Ausführungsbeispiel als Kontaktstifte 1 bzw. Kontaktmesser 2 ausgebildet sind, mit zweiten, zu den ersten Kontaktmitteln 1,2 korrespondierend ausgebildeten Gegenkontaktmitteln 3, die im Ausführungsbeispiel als Kontaktbuchsen 3 ausgebildet sind, kontaktiert werden. Die Richtung des Verschiebens entspricht daher der im Zusammenhang mit dem dem Verrasten des Hakens 9 in der Ausnehmung 8' des Schiebers 8 zitierten Steckrichtung. Die ersten Kontaktmittel 1,2 sind in FIG 1 ersichtlich; die zweiten Kontaktmittel 3 sind in FIG 2 ersichtlich. Neben den Kontakt- und Gegenkontaktmitteln 1,2,3 gelangen beim seitlichen Verschieben der Baugruppe 10 in Richtung auf die aufgeschwenkte Nachbarbaugruppe 10' auch die in FIG 1 ersichtlichen Schutzkrägen 4 mit den entsprechenden, insbesondere formschlüssig ausgebildeten Ausnehmungen 5, die aus FIG 2 ersichtlich sind, zum Eingriff. Die Schutzkrägen schützen die Kontaktmittel 1,2 vor mechanischer Beschädigung; dazu schließt der jeweilige Schutzkragen 5 im Ausführungsbeispiel die Kontaktmittel 1,2 auf mindestens drei Seiten ein. Gegebenenfalls ist auch eine allseitige Einschließung der Kontaktmittel 1,2 bzw. ein unterbrochener Schutzkragen, der die Kontaktmittel 1,2 auf jeweils gegenüberliegenden Seiten einschließt, denkbar. Die im Ausführungsbeispiel im wesentlichen U-förmig ausgestalteten Schutzkrägen 4 greifen in die im Ausführungsbeispiel formschlüssig ausgebildeten Ausnehmungen 5 ein. Prinzipiell ist es auch denkbar, daß mit den Ausnehmungen 5 nur die Außenkontur der Schutzkrägen 4 nachgebildet ist und auf eine Formschlüssigkeit hinsichtlich der Innenkontur der Schutzkrägen 4 verzichtet wird. Die Schutzkrägen 4 sind im Ausführungsbeispiel einstückig mit dem Basismodul 10 bzw. mit dessen Gehäuse verbunden.

Beim Trennen der Baugruppen muß der Schieber 7 über einen Schraubendreher aus seiner Endstellung gebracht werden. Hierzu befindet sich im unteren Bereich des Basismodules 10 eine entsprechende Ausprägung 11, in welche die Klinge des Schraubendrehers zur Betätigung des Schiebers 7 einführbar ist.

Die mit der vorgeschlagenen Lösung verbundenen Vorteile lassen sich wie folgt kurz zusammenfassen:
- Steuerleitungen und Verbindungsleitungen werden über einfache gerade steckbare Steckkontakte ohne Zusatzkontaktmittel übertragen und sind damit z.B. hinsichtlich der Stromtragfähigkeit, des Übergangswiderstand, etc. optimal dimensionierbar, wobei im Ausführungsbeispiel einstückige Kontaktmittel Verwendung finden, die auf der einen Seite in die Kontaktstifte 1 bzw. Kontaktmesser 2 und auf der anderen Seite in die Kontaktbuchsen 3 münden, dabei sind die einstückigen Kontaktmittel gegebenenfalls, insbesondere im Falle der Steuerleitungen, auch durch eine Leiterplatte mit entsprechenden Leiterzügen, mit denen die oben genannten Kontaktmittel 1,2,3 kontaktiert sind, ersetzbar;
- die Schutzkrägen 4 der Steckkontakte 1,2 positionieren den mechanischen Aufbau relativ spielfrei zueinander, so daß Rüttelbeanspruchungen sich nicht auf die Kontaktierung der Basismodule 10, 10' untereinander auswirken;
- die seitliche Verrastung der Basismodule 10, 10' untereinander ist durch die Halterung an der Tragschiene 20 mit dem Federschieber 7 ebenfalls im wesentlichen spielfrei.
Darüber hinaus ergibt sich eine besonders einfache Handhabung, wobei der mechanische Aufwand gering ist, da Standard-Kontaktzonen 1,2,3 Verwendung finden und nur ein Schieberelement 7 für zwei Funktionen (Aufrasten auf der Tragschiene 20 und Arretieren des Modulverbands) zum Einsatz kommt.

Dabei ist insbesondere die Integration der Funktionen sicheres Befestigen auf einem Tragprofil 20 und rüttelsicheres Verbinden der Steuer- und Verbindungsleitungen mit nur einem Funktions- und Bedienelement 7 und dessen Realisierung in einem kleinen Basisteil hervorzuheben.

Ferner ist das Basismodul 10 im Kontaktbereich 13,13', der zur Kontaktierung des nicht dargestellten Elektronikmoduls vorgesehen ist, derart ausgestaltet, daß das Elektronikmodul ausschließlich seitenrichtig an den Kontaktbereich 13,13' heranführbar ist. Dazu sind am Basismodul 10 die mit diesem einstückig verbundenen Führungselemente 12,12' vorgesehen, die mit korrespondierend ausgestalteten Ausnehmungen des Elektronikmoduls zusammenwirken und damit ausschließlich das seitenrichtige Heranführen des Elektronikmoduls an den Kontaktbereich ermöglichen. Die Führungselemente 12,12' sind dabei derart ausgestaltet, daß das seitenrichtige Heranführen gewährleistet ist, bevor die Kontaktelemente 13,13' zum elektrisch leitenden Kontaktieren des Elektronikmoduls mit dem Basismodul 10 zum Eingriff kommen.

Zusammenfassend läßt sich die vorliegende Erfindung wie folgt kurz beschreiben: Es wird ein modular aufbaubares Automatisierungsgerät angegeben, welches aus Basisbaugruppen besteht, welche auf einer Hutschiene aufreihbar sind und mit Elektronikbaugruppen (E/A-Modulen) bestückt werden, wobei die Basisbaugruppe neben Steuerleitungen auch stromtragfähige Verbindungsleitungen aufweist, die zur Kontaktierung auf der einen Außenseite der Baugruppe in Kontaktstifte und auf der gegenüberliegenden Außenseite in Kontaktbuchsen münden, wobei die Kontaktstifte von einem Schutzkragen zumindest teilweise umschlossen sind, der beim Zusammenschieben benachbarter Baugruppen in eine korrespondierend ausgestaltete Ausnehmung im Bereich der Kontaktbuchsen formschlüssig einführbar ist. Der Vorteil der vorliegenden Erfindung besteht darin, daß die Handhabungen im Zusammenhang einerseits mit dem Befestigen der Module auf der Tragschiene und anderseits mit dem Kontaktieren mit Nachbarmodulen sehr schnell und einfach vonstatten gehen und sich der hierfür notwendige technische Aufwand auf ein Minimum beschränkt.

## Patentansprüche

1. Modulares Automatisierungsgerät mit anreihbaren, auf einer Tragschiene (20) gehaltenen Basismodulen (10) mit Außenkontakten, wobei das Basismodul (10) mit einem Elektronikmodul kontaktierbar ist, das selbst keine Außenkontakte aufweist, und wobei das Basismodul (10) mit einem benachbarten Basismodul (10') kontaktierbar ist, wobei
- das Basismodul (10) neben Steuerleitungen auch stromtragfähige Verbindungsleitungen aufweist, die zur Kontaktierung auf der einen Außenseite des Basismoduls (10) in ersten Kontaktmitteln (1,2) und auf der gegenüberliegenden Außenseite des Basismoduls (10) in zweiten, zu den ersten Kontaktmitteln (1,2) korrespondierend ausgebildeten Gegenkontaktmitteln (3) münden,
**dadurch gekennzeichnet,**
- **daß** in räumlichem Zusammenhang mit den ersten Kontaktmitteln (1,2) ein Schutzkragen (4) vorgesehen ist und in räumlichem Zusammenhang mit den Gegenkontaktmitteln (3) eine zu dem Schutzkragen (4) formschlüssig korrespondierende Ausnehmung (5) vorgesehen ist.

2. Modulares Automatisierungsgerät nach Anspruch 1, **dadurch gekennzeichnet, daß** der Schutzkragen einstückig mit dem Basismodul (10) verbunden ist.

3. Modulares Automatisierungsgerät nach Anspruch 1 oder 2, **dadurch gekennzeichnet, daß** zum Aufrasten des Basismoduls (10) auf die Tragschiene (20) Vorrichtungen (6,7) zum beidseitigen Eingriff mit der Tragschiene (20) vorgesehen sind, wobei die erste Vorrichtung (6) eine im wesentlichen hakenförmige Ausnehmung (6) des Basismoduls (10) ist und wobei die zweite Vorrichtung (7) ein beweglich gelagerter, insbesondere gefederter, Schieber (7) ist.

4. Modulares Automatisierungsgerät nach Anspruch 3, **dadurch gekennzeichnet, daß** mit dem Schieber (7) verbunden oder mit diesem betätigbar eine Verlängerung (8) vorgesehen ist, die einen in eine korrespondierende Ausnehmung (8') eingeführten Haken (9) eines Nachbarmoduls (10) in der Ausnehmung (8') arretiert.

5. Anreihbares, auf einer Tragschiene (20) gehaltenes Basismodul (10) eines modularen Automatisierungsgerätes, wobei das Basismodul (10) Außenkontakte aufweist, wobei das Basismodul (10) mit einem Elektronikmodul kontaktierbar ist, das selbst keine Außenkontakte aufweist, und wobei das Basismodul (10) mit einem benachbarten Basismodul (10') kontaktierbar ist, wobei
- das Basismodul (10) neben Steuerleitungen auch stromtragfähige Verbindungsleitungen aufweist, die zur Kontaktierung auf der einen Außenseite des Basismoduls (10) in ersten Kontaktmitteln (1,2) und auf der gegenüberliegenden Außenseite des Basismoduls (10) in zweiten, zu den ersten Kontaktmitteln (1,2) korrespondierend ausgebildeten Gegenkontaktmitteln (3) münden,
**dadurch gekennzeichnet,**
- **daß** in räumlichem Zusammenhang mit den ersten Kontaktmitteln (1,2) ein Schutzkragen (4) vorgesehen ist und in räumlichem Zusammenhang mit den Gegenkontaktmitteln (3) eine zu dem Schutzkragen (4) formschlüssig korrespondierende Ausnehmung (5) vorgesehen ist.

6. Basismodul nach Anspruch 5, **dadurch gekennzeichnet, daß** der Schutzkragen einstückig mit dem Basismodul (10) verbunden ist.

7. Basismodul nach Anspruch 5 oder 6, dadurch gekennzechnet, daß zum Aufrasten des Basismoduls (10) auf die Tragschiene (20) Vorrichtungen (6,7) zum beidseitigen Eingriff mit der Tragschiene (20) vorgesehen sind, wobei die erste Vorrichtung (6) eine im wesentlichen hakenförmige Ausnehmung (6) des Basismoduls (10) ist und wobei die zweite Vorrichtung (7) ein beweglich gelagerter, insbesondere gefederter, Schieber (7) ist.

8. Basismodul nach Anspruch 7, **dadurch gekennzeichnet, daß** mit dem Schieber (7) verbunden oder mit diesem betätigbar eine Verlängerung (8) vorgesehen ist, die einen in eine korrespondierende Ausnehmung (8') eingeführten Haken (9) einer Nachbarbaugruppe (10) in der Ausnehmung (8') arretiert.

## Claims

1. Modular automation unit with basic modules (10) which can be joined together arranged along a mounting rail (20) with external contacts, where the basic module (10) can make contact with an electronic module which does not itself have any external contacts, and where the basic module (10) with is able to establish contact with a neighboring basic module (10'), where
- the basic module (10) in addition to control lines, also features connecting lines capable of carrying current, which, to establish the contact, end on one external side of the basic module (10) in first contact means (1,2) and on the opposite external side of the basic module (10) in second, opposing contact means (1,2) embodied to correspond to them (3),
**characterized in that**
- a protective shroud (4) is provided in the space around the first contact means (1,2) and in the space around the opposing contact means (3) a tightly-fitting cutout (5) corresponding to the protective shroud (4) is provided

2. Modular automation unit in accordance with Claim 1,
**characterized in that**
the protective shroud is connected in one piece to the basic module (10).

3. Modular automation unit in accordance with Claim 1 or 2,
**characterized in that**
to latch the basic module (10) onto the mounting rail (20) devices (6,7) for engaging with both sides of the mounting rail (20) are provided, where the first device (6) is an essentially hook-shaped cutout (6) of the basic module (10) and where the second device (7) is a movable, especially spring-loaded slider (7).

4. Modular automation unit in accordance with Claim 3,
**characterized in that**
an extension (8) connected to the slider (7) or able to be actuated by it is provided which latches a hook (9) introduced into a corresponding cutout (8') of a neighboring module (10) in the cutout (8').

5. Basic modules (1) of a modular automation device which can be joined in an arrangement on a mounting rail (20), where the basic module (10) features external contacts, where the basic module (10) can be contacted with the electronic module which does not itself have external contacts and where the basic module (10) can be contacted with a neighboring basic module (10'), where
- the basic module (10) in addition to control lines, also features connecting lines capable of carrying current, which, to establish the contact, end on one external side of the basic module (10) in first contact means (1,2) and on the opposite external side of the basic module (10) in second, opposing contact means (1,2) embodied to correspond to them (3),
in which,
- a protective shroud (4) is provided in the space around the first contact means (1,2) and in the space around the opposing contact means (3) a tightly-fitting cutout (5) corresponding to the protective shroud (4) is provided

6. Basic module in accordance with Claim 5, **characterized in that** the basic shroud is connected with the basic module(10) as one piece.

7. Basic module in accordance with Claims 5 or 10, **characterized in that**, to latch the basic module (10) onto the mounting rail (20) devices (6, 7) for engaging with both sides of the mounting rail (20) are provided, where the first device (6) is an essentially hook-shaped cutout (6) of the basic module (10) and where the second device (7) is a movable, especially spring-loaded slider (7).

8. Basic module in accordance with Claim 7, **characterized in that** with an extension (8) connected to the slider (7) or able to be actuated by it is provided which latches a hook (8) introduced into a corresponding cutout (8') of a neighboring module (9) in the cutout (8').

## Revendications

1. Automate modulaire comportant des modules de base (10) à contacts extérieurs pouvant être enfilés sur un rail de support (20), le module de base (10) pouvant être mis en contact avec un module électronique qui ne comporte pas lui-même de contact extérieur et le module de base (10) pouvant être mis en contact avec un module de base voisin
- le module de base (10) comportant, en plus des lignes de commande, également des lignes de liaison pour le transport du courant qui, pour réaliser le contact, débouchent sur l'un des côtés extérieurs du module de base (10) dans des premiers moyens de contact (1, 2) et du côté extérieur opposé des modules de base (10) dans des deuxièmes moyens de contact homologues (3), conformés en correspondance des premiers moyens de contact (1, 2),
**caractérisé en ce qu'**il est prévu un rebord de protection (4) dans une relation spatiale avec les premiers moyens de contact (1, 2) et un creux correspondant (5) à complémentarité de forme, par rapport au rebord de protection (4), dans une relation spatiale avec les moyens de contact homologues (3).

2. Automate modulaire selon la revendication 1, **caractérisé en ce que** le rebord de protection est d'un seul tenant avec le module de base (10).

3. Automate modulaire selon la revendication 1 ou 2, **caractérisé en ce qu'**il est prévu des dispositifs (6, 7) pour l'engagement bilatéral avec le rail de support (20) afin d'encliqueter le module de base (10) sur le rail de support (20), le premier dispositif (6) étant formé par un creux (6), sensiblement en forme de crochet, du module de base (10) et le deuxième dispositif (7) étant formé par le coulisseau (7) monté de façon mobile et en particulier contraint par ressort.

4. Automate modulaire selon la revendication 3, **caractérisée en ce qu'**il est prévu un prolongement (8) qui est relié au coulisseau (7), ou qui peut être actionné par celui-ci, et qui bloque un crochet (9), inséré dans un creux correspondant (8'), d'un module voisin (10) dans un creux (8').

5. Module de base (10), pouvant être enfilé en série sur un rail de support (20), d'un automate modulaire, le module de base (10) comportant des contacts extérieurs, le module de base (10) pouvant être mis en contact avec un module électronique qui ne comporte pas lui-même de contact extérieur, et le module de base (10) pouvant être mis en contact avec un module de base voisin (10'),
- le module de base (10) comportant, en plus des lignes de commande, également des lignes de liaison pour le transport du courant qui, pour réaliser le contact, débouchent sur l'un des côtés extérieurs du module de base (10) dans des premiers moyens de contact (1, 2) et du côté extérieur opposé des modules de base (10) dans des deuxièmes moyens de contact homologues (3), conformés en correspondance des premiers moyens de contact (1, 2),
**caractérisé en ce qu'**il est prévu un rebord de protection (4) dans une relation spatiale avec les premiers moyens de contact (1, 2) et un creux correspondant (5) à complémentarité de forme, par rapport au rebord de protection (4), dans une relation spatiale avec les moyens de contact homologues (3).

6. Module de base selon la revendication 5, **caractérisé en ce que** le rebord de protection d'un seul tenant avec le module de base (10).

7. Module de base selon la revendication 5 ou 6, **caractérisé en ce qu'**il est prévu des dispositifs (6, 7) pour l'engagement bilatéral avec le rail de support (20) afin d'encliqueter le module de base (10) sur le rail de support (20), le premier dispositif (6) étant formé par un creux (6), sensiblement en forme de crochet, du module de base (10) et le deuxième dispositif (7) étant formé par le coulisseau (7) monté de façon mobile et en particulier contraint par ressort.

8. Module de base selon la revendication 3, **caractérisée en ce qu'**il est prévu un prolongement (8) qui est relié au coulisseau (7), ou qui peut être actionné par celui-ci, et qui bloque un crochet (9), inséré dans un creux correspondant (8'), d'un module voisin (10) dans un creux (8').
